# EUROPÄISCHE PATENTANMELDUNG

(11) **EP 0 735 620 A2**
(43) Veröffentlichungstag der Anmeldung: **02.10.1996**
(21) Anmeldenummer: 96103553.2
(22) Anmeldetag: 06.03.1996
(51) Int. Cl.: H01R 13/629

(54) **Betätigungshilfe zum Bringen und/oder Lösen eines elektrischen Verbinders in bzw. aus dessen Verbindungsstellung**

(30) Priorität: 29.03.1995 DE 19511509
(71) Anmelder: SIEMENS AKTIENGESELLSCHAFT, 80333 München (DE)
(72) Erfinder: Longueville, Jacques, B-8020 Oostkamp (BE); Pagnin, Peter, D-80995 München (DE)

(57) **Zusammenfassung**

Es wird eine Betätigungshilfe beschrieben, zum Bringen und/oder Lösen eines elektrischen Verbinders in bzw. aus dessen Verbindungsstellung, in welcher er eine erste Leiterplatte mit einer zweiten Leiterplatte elektrisch verbindet. Die Betätigungshilfe zeichnet sich dadurch aus, daß ein dem elektrischen Verbinder zugewandter Endabschnitt der Betätigungshilfe derart ausgebildet ist, daß damit ein Haltemechanismus betätigbar ist, welcher in der Lage ist, den elektrischen Verbinder in der Verbindungsstellung zu halten, und daß ein dem elektrischen Verbinder abgewandter Endabschnitt der Betätigungshilfe sich in einen Bereich außerhalb der ersten und/oder zweiten Leiterplatte erstreckt und so ausgebildet ist, daß eine Betätigung dieses Endabschnittes eine Betätigung des Haltemechanismus durch den dem elektrischen Verbinder zugewandten Endabschnitt der Betätigungshilfe auslöst.

## Beschreibung

Die vorliegende Erfindung bezieht sich auf eine Betätigungshilfe zum Bringen und/oder Lösen eines elektrischen Verbinders in bzw. aus dessen Verbindungsstellung, in welcher er eine erste Leiterplatte mit einer zweiten Leiterplatte elektrisch verbindet.

Elektrische Verbinder zur Verbindung von Leiterplatten sind in einer großen Vielfalt bekannt.

Stellvertretend sei in diesem Zusammenhang beispielsweise auf die von der Anmelderin hergestellte und vertriebene 2,5-mm-Steckverbinderfamilie "SIPAC" verwiesen. Beschreibungen des Basismodells und von Weiterentwicklungen dieses elektrischen Verbinders sind in "Components", 30 (1992), Heft 5, Seiten 189 - 192 sowie in "Markt und Technik - Wochenzeitung für Elektronik", Nr. 26 vom 24. Juni 1994, Seiten 36 bis 37 veröffentlicht.

Der Umstand, daß infolge der Bemühungen, derartige elektrische Verbinder HF-tauglich zu machen, in der Regel eine Vielzahl zusätzlicher Massekontakte vorgesehen wird und ferner die Tatsache, daß mit dem Fortschreiten der Technik die Anzahl von zu übertragenden Signalen und damit sowohl die Anzahl der Übertragungsleitungen als auch die Übertragungsgeschwindigkeit eher zu- als abnimmt, führen dazu, daß die Handhabung der herkömmlichen elektrischen Verbinder immer schwieriger und aufwendiger wird.

Je hochpoliger die herkömmlichen elektrischen Verbinder werden, desto größer sind nämlich die Kräfte, die beim Einstecken und Herausziehen in bzw. aus zur Kontaktierung dienenden Kontaktleisten wie Messer- oder Federleisten erforderlich sind.

Hinzu kommt, daß der erforderliche Kraftaufwand unweigerlich auch zu einer Verformung der zu verbindenden oder zu trennenden Leiterplatten führt und dabei die auf den Leiterplatten montierten Bauteile, insbesondere oberflächenmontierte Bauteile gefährdet werden.

Bekannte Betätigungshilfen zum Herstellen und Lösen einer elektrischen Steckverbindung sind insbesondere bei Leiterplattenverbindern in der Regel nicht einsetzbar, weil diese normalerweise sehr schlecht zugänglich sind.

Ferner können die bekannten Betätigungshilfen zwar dazu beitragen, den vom Benutzer aufzubringenden Kraftaufwand zu reduzieren, doch bleiben die auf die Leiterplatten wirkenden Kräfte und die damit verbundenen Gefahren und Nachteile unverändert bestehen.

Der vorliegenden Erfindung liegt daher die Aufgabe zugrunde, eine Betätigungshilfe gemäß dem Oberbegriff des Patentanspruchs 1 derart weiterzubilden, daß dieser auch bei Leiterplattenverbindern und auf eine Art einsetzbar ist, durch die die Belastung der Leiterplatten beim Herstellen und Lösen der Verbindung einfach und zuverlässig auf ein Minimum reduzierbar ist.

Diese Aufgabe wird erfindungsgemäß durch die im kennzeichnenden Teil des Patentanspruchs 1 beanspruchten Merkmale gelöst.

Demnach ist vorgesehen, daß ein dem elektrischen Verbinder zugewandter Endabschnitt der Betätigungshilfe derart ausgebildet ist, daß damit ein Haltemechanismus betätigbar ist, welcher in der Lage ist, den elektrischen Verbinder in der Verbindungsstellung zu halten, und daß ein dem elektrischen Verbinder abgewandter Endabschnitt der Betätigungshilfe sich in einen Bereich außerhalb der ersten und/oder zweiten Leiterplatte erstreckt und so ausgebildet ist, daß eine Betätigung dieses Endabschnittes eine Betätigung des Haltemechanismus durch den dem elektrischen Verbinder zugewandten Endabschnitt der Betätigungshilfe auslöst.

Erfindungsgemäß ist die Betätigungshilfe also derart ausgebildet, daß nicht etwa einfach der Vorgang des Einsteckens oder Herausziehens einer Leiterplatte auf eine andere bzw. von einer anderen Leiterplatte unterstützt wird, sondern daß durch die Betätigungshilfe nur der den elektrischen Verbinder in der Verbindungsstellung haltende Haltemechanismus betätigbar ist, und zwar ohne die verbundenen oder zu verbindenden Leiterplatten örtlich voneinander zu trennen. D.h., es ist - anders als bei den bekannten Betätigungshilfen - möglich, das Herstellen und das Lösen der mechanischen und elektrischen Verbindung zwischen dem elektrischen Verbinder und einer damit zu kontaktierenden bzw. kontaktierten Leiterplatte einerseits und das Einführen und das Herausnehmen der Leiterplatte in bzw. aus dem elektrischen Verbinder andererseits vollkommen voneinander zu trennen. Das Einführen und das Herausnehmen der Leiterplatte in bzw. aus dem elektrischen Verbinder kann bei Verwendung des durch den mittels der erfindungsgemäßen Betätigungshilfe fernbedienbaren Haltemechanismus ohne Kraftaufwand und damit ohne Gefahr für die Leiterplatte erfolgen.

Die Tatsache, daß nur der den elektrischen Verbinder in der Verbindungsstellung haltende Haltemechanismus betätigt werden muß, läßt eine bezüglich der Verbinderposition asymmetrische Anordnung der Betätigungshilfe zu und ermöglicht damit die Verwendung der erfindungsgemäßen Betätigungshilfe auch bei umfangreich bestückten und/oder in geringem Abstand benachbarten Leiterplatten.

Die Herausführung des dem elektrischen Verbinder abgewandten Endabschnittes der Betätigungshilfe nach außerhalb der Leiterplatten eröffnet zudem die Möglichkeit, durch den Einsatz einer Betätigungshilfe verursachbare Schäden, beispielsweise infolge eines Biegens der Leiterplatte wegen der schlechten Zugänglichkeit der Verbindung, zu vermeiden.

Die erfindungsgemäße Betätigungshilfe ist mithin auch bei Leiterplattenverbindern und auf eine Art einsetzbar, daß eine Belastung der Leiterplatten beim Herstellen und Lösen der Verbindung einfach und zuverlässig auf ein Minimum reduzierbar ist.

Vorteilhafte Weiterbildungen der Erfindung sind Gegenstand der Unteransprüche.

Die Erfindung wird nachfolgend anhand von Ausführungsbeispielen unter Bezugnahme auf die Zeichnung näher erläutert. Es zeigen
- Figur 1: eine schematische Ansicht von zwei Leiterplatten, die erfindungsgemäß unter Verwendung einer geeigneten Betätigungshilfe über einen elektrischen Verbinder in Verbindung bringbar sind,
- Figur 2A: den Zustand, in dem eine Baugruppen-Leiterplatte in eine Aussparung des elektrischen Verbinders einführbar ist,
- Figur 2B: den Zustand, in dem die Baugruppen-Leiterplatte in die Aussparung des elektrischen Verbinders eingeführt wurde, und
- Figur 2C: den Zustand, in dem der elektrische Verbinder durch die erfindungsgemäße Betätigungshilfe in seine Verbindungsstelle gebracht wurde.

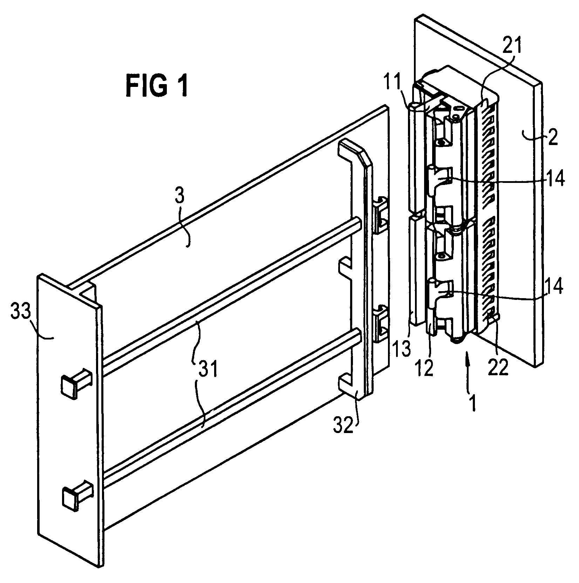

Figur 1 zeigt eine schematische Ansicht von zwei Leiterplatten, die erfindungsgemäß unter Verwendung einer geeigneten Betätigungshilfe über einen elektrischen Verbinder in Verbindung bringbar sind.

Der elektrische Verbinder ist mit Bezugszeichen 1 bezeichnet. Die durch den elektrischen Verbinder in Verbindung zu bringenden Leiterplatten sind eine Rückwand-Leiterplatte 2 und eine Baugruppen-Leiterplatte 3.

Durch die Verbindung sollen die Oberfläche der Rückwand-Leiterplatte 2 und eine oder beide Oberfläche(n) der Baugruppen-Leiterplatte 3, genauer gesagt auf den jeweiligen Oberflächen vorgesehene Kontaktpunkte elektrisch miteinander verbunden werden, wobei im Verbindungszustand die Baugruppen-Leiterplatte 3 unter Zwischenschaltung des elektrischen Verbinders 1 auf die Oberfläche der Rückwand-Leiterplatte 2 aufgesteckt ist.

Der elektrische Verbinder 1 wird durch auf der Rückwand-Leiterplatte 2 montierte Führungs- und Haltewände 21 auf der Rückwand-Leiterplatte 2 gehalten. Die Führungs- und Haltewände 21 weisen eine Vielzahl von Verbinder-Arretierungsvorrichtungen in Form von nach innen ragenden federnden Haltelappen 22 auf, welche in im Gehäuse des elektrischen Verbinders 1 vorgesehene, nicht gezeigte Aussparungen einrasten und im Verbindungszustand für eine sichere mechanische und elektrische Verbindung zwischen dem elektrischen Verbinder 1 und der Rückwand-Leiterplatte 2 sorgen.

Der elektrische Verbinder 1 weist an seinem gemäß der Figur 1 der Baugruppen-Leiterplatte 3 zugewandten Ende eine Aussparung 11 zur Aufnahme der Baugruppen-Leiterplatte 3 auf.

Um die Größe der Aussparung 11 variieren zu können, weist der elektrische Verbinder eine erste Hälfte 12 und eine zweite Hälfte 13 auf, welche an dem der Baugruppen-Leiterplatte 3 zugewandten Ende in einem gewissen Ausmaß auseinander- und zusammenklappbar sind.

In der Figur 1 ist der elektrische Verbinder 1 in einer Montagestellung dargestellt, in welcher dessen erste Hälfte 12 und dessen zweite Hälfte 13 auseinandergeklappt sind. In diesem Zustand ist die Aussparung 11 relativ groß und ermöglicht ein im wesentlichen kraftfreies Einführen der Baugruppen-Leiterplatte 3 in die Aussparung 11.

In der in der Figur 1 nicht gezeigten Verbindungsstellung des elektrischen Verbinders sind die erste Hälfte 12 und die zweite Hälfte 13 des elektrischen Verbinders 1 so weit zusammengeklappt, daß zwischen den Oberflächen der Baugruppen-Leiterplatte 3 und der ersten und der zweiten Hälfte des elektrischen Verbinders eine sichere und zuverlässige elektrische und mechanische Verbindung gewährleistet ist. In diesem Zustand ist ein Herausziehen der Baugruppen-Leiterplatte 3 aus dem elektrischen Verbinder 1 allenfalls unter Beschädigung der Baugruppen-Leiterplatte und/oder des elektrischen Verbinders möglich.

Um die erste und die zweite Hälfte des elektrischen Verbinders von der Montagestellung in die Verbindungsstellung oder umgekehrt zu bringen, muß ein am elektrischen Verbinder vorgesehener Haltemechanismus in Form von einem oder mehreren Kniehebeln 14 betätigt werden. Gemäß dem vorliegenden Ausführungsbeispiel sind zwei Kniehebel 14 vorgesehen.

Wie später noch genauer beschrieben werden wird, zwingt die Ausübung einer Andruckkraft auf die Kniehebel 14 den elektrischen Verbinder in dessen Verbindungsstellung. Die Kniehebel werden bei diesem Vorgang gestreckt und schließlich über deren Totpunkt durchgedrückt. Nach dem Passieren des Totpunkts rasten die Kniehebel in eine Endstellung ein, welche sie ohne weitere Kraftzuführung beibehalten. In diesem Zustand hat der elektrische Verbinder seine Verbindungsstellung eingenommen, in welcher er die Rückwand-Leiterplatte 2 mit der Baugruppen-Leiterplatte 3 elektrisch verbindet.

Durch Ausübung einer Zugkraft auf die Kniehebel 14 läßt sich der elektrische Verbinder wieder in dessen Montagestellung bringen. Vorteilhafter Weise ist der Haltemechanismus so ausgebildet, daß der elektrische Verbinder bei diesem Vorgang in die Montagestellung gezwungen wird.

Um die am elektrischen Verbinder angebrachten Kniehebel von einem vom elektrischen Verbinder entfernten Punkt betätigen zu können, ist die erfindungsgemäße Betätigungshilfe in Form von einer oder mehreren Druckstangen 31 vorgesehen. Gemäß dem vorliegenden Ausführungsbeispiel sind zwei nebeneinander verlaufende Druckstangen 31 vorgesehen.

Die Druckstangen 31 werden durch entsprechende Öffnungen in einem an der Baugruppen-Leiterplatte 3 montierten Führungssteg 32 und einer ebenfalls an der Baugruppen-Leiterplatte 3 montierten Abschlußblende 33 parallel zur Oberfläche der Baugruppen-Leiterplatte geführt.

Die Druckstangen können an beliebigen Stellen entlang des Kniehebelsystems angeordnet werden. Dieser Umstand und ferner die Tatsache, daß die Druckstange in beliebigem Abstand von der Oberfläche der Baugruppen-Leiterplatte geführt werden kann, bieten eine maximale Freiheit bei der Bestückung der Baugruppen-Leiterplatte.

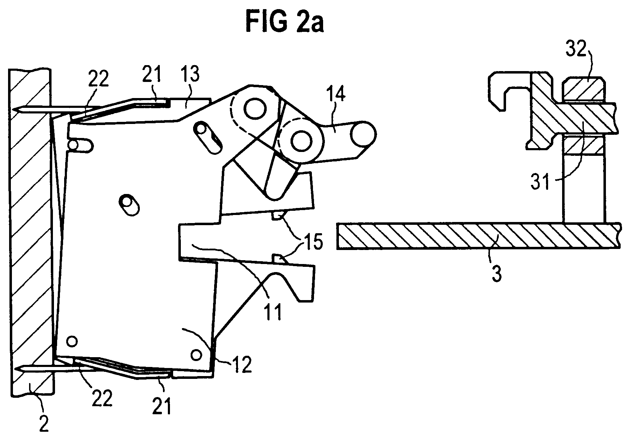

Zur genauen Erläuterung der Funktion und des Zusammenwirkens der Druckstangen 31 und der Kniehebel 14 wird nun auf die Figuren 2A bis 2C Bezug genommen.

Die Figuren 2A bis 2C veranschaulichen das Herstellen der Verbindung zwischen dem elektrischen Verbinder 1 und der Baugruppen-Leiterplatte 3.

Die Figur 2A zeigt den elektrischen Verbinder in dessen Montagestellung. In diesem Zustand sind die erste Hälfte 12 und die zweite Hälfte 13 auseinandergeklappt, um die Leiterplatten-Aussparung 11 im elektrischen Verbinder so weit zu öffnen, daß die Baugruppen-Leiterplatte 3 ohne Aufwendung von Kraft in diese einführbar ist.

Bemerkenswert ist hier, daß die erste Hälfte 12 und die zweite Hälfte 13 des elektrische Verbinders durch ihre besondere Ausgestaltung auch dann zusammen- und auseinanderklappbar sind, wenn der elektrische Verbinder 1 zwischen die Führungs- und Haltewände 21 eingebracht ist und von den Haltelappen 22 dort gehalten wird.

Beim Zusammen- und Auseinanderklappen der ersten Hälfte 12 und der zweiten Hälfte 13 des elektrischen Verbinders werden die Hälften um jeweilige Endabschnitte der Haltelappen 22 in zueinander entgegengesetzten Richtungen geschwenkt. Da die jeweils als Drehpunkte wirkenden Haltelappen 22 nie die entsprechenden Aussparungen im Verbindergehäuse verlassen, können die Hälften des elektrischen Verbinders weder im Verbindungszustand noch im Montagezustand des elektrischen Verbinders aus den Führungs- und Haltewänden 21 herausfallen.

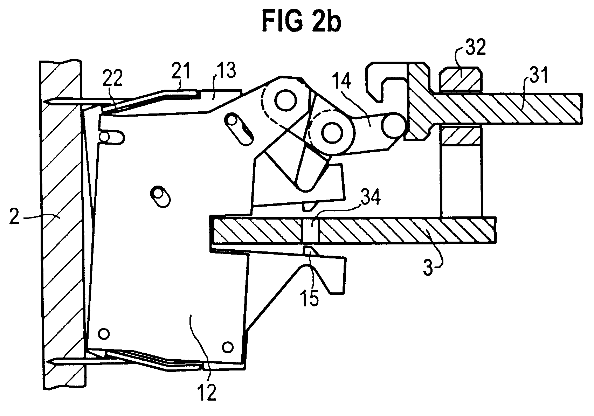

Der Zustand, in welchem die Baugruppen-Leiterplatte in die Aussparung des elektrischen Verbinders eingebracht ist, ist in der Figur 2B gezeigt.

Gemäß Figur 2B befindet sich der elektrische Verbinder nach wie vor in der Montagestellung. Das Einschieben der Baugruppen-Leiterplatte 3 in die entsprechende Aussparung 11 im elektrischen Verbinder ändert hieran nichts.

In dem in der Figur 2B gezeigten Zustand besteht zwischen der Baugruppen-Leiterplatte 3 und dem elektrischen Verbinder 1 weder eine mechanische noch eine elektrische Verbindung. Beides erfolgt erst durch Bringen des elektrischen Verbinders in die Verbindungsstellung, was folgendermaßen abläuft:

Ausgehend von der in der Figur 2B gezeigten Stellung werden durch den Bediener die Druckstangen 31 zum elektrischen Verbinder hin gedrückt. Durch diese Betätigung der Druckstangen 31 kommen diese in Kontakt mit den ihnen jeweils zugeordneten Kniehebeln 14 und üben auf diese einen Druck aus.

Hieraus ergeben sich zwei Konsequenzen. Zum einen wird diejenige Hälfte des elektrischen Verbinders, an welcher der Kniehebel befestigt ist, d.h. im vorliegenden Fall die erste Hälfte in Richtung der Rückwand-Leiterplatte 2 gedrückt, so daß sie um die Haltelappen 22 der Führungs- und Haltewände 21 eine allmählich zur Verbindungsstellung des elektrischen Verbinders führende Schwenkbewegung ausführt. Andererseits wird infolge des zunehmenden Streckens des Kniehebels über diesen auch eine Kraft auf die mit einem Endabschnitt des Kniehebels 14 direkt oder über einen Flansch oder dergleichen in Eingriff stehende andere Hälfte des elektrischen Verbinders ausgeübt, so daß auch diese um die Haltelappen 22 der Führungs- und Haltewände 21 eine allmählich zur Verbindungsstellung des elektrischen Verbinders führende Schwenkbewegung ausführt.

Ein wie vorstehend beschrieben betätigbarer Haltemechanismus eröffnet die Möglichkeit, auf das Vorsehen von üblicherweise zum Ansetzen der herkömmlichen Betätigungshilfen erforderlichen, nicht mit Bauteilen bestückten Freiräumen auf den jeweiligen Leiterplatten zu verzichten.

Die um einander gegenüberliegende Haltelappen 22 ausgeführten Schwenkbewegungen der ersten und der zweiten Hälfte des elektrischen Verbinders erfolgen in entgegengesetzte Richtungen und bringen den elektrischen Verbinder schließlich, wenn der Kniehebel 14 über den Totpunkt durchgedrückt wird, in die Verbindungsstellung.

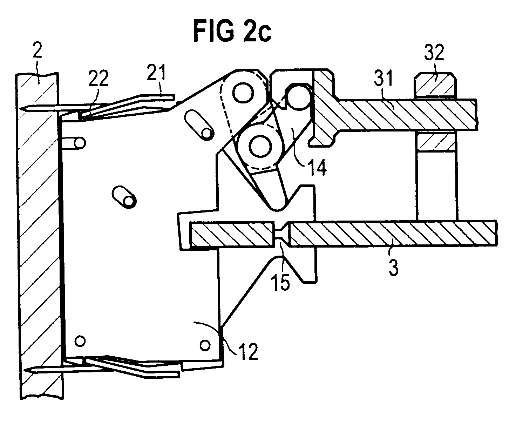

Die Verbindungsstellung des elektrischen Verbinders ist in Figur 2C gezeigt. Obwohl die erste und die zweite Hälfte des elektrischen Verbinders aus später noch genauer beschriebenen Gründen das starke Bestreben haben, in die Montagestellung zurückzukehren, wird die Verbindungstellung infolge der sperrenden Wirkung des Kniehebels in dieser Position beibehalten. Die Druckstangen sind in diesem Zustand kraftfrei.

In der Verbindungsstellung des elektrischen Verbinders sind, wie der Name schon sagt, sowohl die Rückwand-Leiterplatte 2 als auch die Baugruppen-Leiterplatte 2 sowohl mechanisch als auch elektrisch fest mit dem elektrischen Verbinder verbunden.

Die mechanische und elektrische Verbindung zwischen der Rückwand-Leiterplatte und dem elektrischen Verbinder erfolgt durch das Einschwenken der ersten und der zweiten Hälfte des elektrischen Verbinders in die Verbindungsstellung. Hierdurch werden nämlich, wie aus den Figuren 2A und 2B einerseits, und der Figur 2C andererseits ersichtlich ist, die zunächst von der Rückwand-Leiterplatte stellenweise deutlich beabstandeten Hälften des elektrischen Verbinders gleichmäßig und fest auf die Rückwand-Leiterplatte gedrückt.

Die mechanische Verbindung zwischen der Baugruppen-Leiterplatte und dem elektrischen Verbinder kommt dadurch zustande, daß die Baugruppen-Leiterplatte 3 in der Verbindungsstellung zwischen der ersten Hälfte und der zweiten Hälfte des elektrischen Verbinders 1 eingespannt ist. Darüber hinaus wird die Baugruppen-Leiterplatte in diesem Zustand zusätzlich auch durch an der ersten und der zweiten Hälfte vorgesehene Vorsprünge 15 gehalten, welche im Verbindungszustand des elektrischen Verbinders in entsprechende Aussparungen 34 auf der Baugruppen-Leiterplatte 3 eingreifen.

Die elektrische Verbindung zwischen der Baugruppen-Leiterplatte und dem elektrischen Verbinder kommt dadurch zustande, daß im eingespannten Bereich der oberen und/oder unteren Oberfläche der Baugruppen-Leiterplatte nicht gezeigte Kontaktierungsvorrichtungen vorgesehen sind, welche im Verbindungszustand von auf an entsprechend angeordneten Kontaktierungsvorrichtungen auf der ersten und zweiten Hälfte des elektrischen Verbinders kontaktiert werden.

Diese Kontaktierungsvorrichtungen können von beliebiger Art sein. Es kann sich dabei um herkömmliche Messer- und Federleisten oder aber auch um gänzlich andere Vorrichtungen handeln.

Besonders vorteilhaft ist hier die Ausbildung der beiderseitigen Kontaktierungsvorrichtungen als im wesentlichen ebene Kontaktflächen, welche im Verbindungszustand im wesentlichen frontal aufeinandergepreßt werden. Das Aufeinanderpressen kann allein durch das Einspannen der Baugruppen-Leiterplatte 3 zwischen die erste und die zweite Hälfte des elektrischen Verbinders 1 erfolgen, kann aber auch ausschließlich oder zusätzlich mittels in den Kontaktierungsvorrichtungen vorgesehenen, die einander zugeordneten Kontaktflächen aneinanderdrückenden elastischen Elementen wie Federn oder dergleichen erfolgen.

Versieht man die Kontaktierungsvorrichtungen beispielsweise mit Federn, trägt dies einerseits zu einer sichereren und zuverlässigeren Kontaktierung bei, und erleichtert, ja unterstützt andererseits sogar das Aufklappen der ersten und der zweiten Hälfte des elektrischen Verbinders beim Übergang von der Verbindungsstellung in die Montagestellung.

Wenngleich die elektrische Verbindung vorstehend detailliert nur für die Verbindung zwischen der Baugruppen-Leiterplatte und dem elektrischen Verbinder beschrieben wurde, so gelten die hierbei gemachten Ausführungen jedoch in entsprechender Weise auch für die elektrische Verbindung zwischen der Rückwand-Leiterplatte und dem elektrischen Verbinder.

Wie aus den Figuren 2B und 2C ersichtlich ist, verändert sich bei fortgesetztem Drücken der Druckstange auf den Kniehebel deren Berührungspunkt bzw. deren Berührungsfläche.

Spätestens bei Erreichen des Totpunkts des Kniehebels 14 hat sich der Berührungspunkt an der Druckstange 31 gemäß den in den Figuren 2A bis 2C gezeigten Darstellungen so weit nach oben verschoben, daß er in einem in den Figuren gut erkennbaren hakenförmig ausgebildeten Bereich der Druckstange zu liegen kommt, so daß eine bei entsprechend weitem Zurückziehen der Druckstange zwar lösbare, aber vorübergehend gleichwohl feste Verbindung zwischen dem Kniehebel 14 und der Druckstange 31 gebildet wird.

In der Verbindungsstellung des elektrischen Verbinders ist die Druckstange 31 demnach zusammen mit dem Kniehebel 14 in eine Haltestellung eingerastet.

Die in der Verbindungsstellung des elektrischen Verbinders eingenommene Druckstangenstellung und das Einrasten in diese Stellung beim Durchdrücken des Kniehebels über dessen Totpunkt geben dem Bediener Möglichkeiten an die Hand, die vom elektrischen Verbinder jeweils gerade eingenommene Stellung zu bestimmen.

Der Fall, daß die Druckstange nicht in ihre Endstellung hör- und spürbar einrastet und/oder daß die Druckstange übermäßig wenig oder weit aus der Abschlußblende 33 der Baugruppen-Leiterplatte hervorsteht, was beispielsweise anhand von Farbmarkierungen oder dergleichen überprüft werden kann, ist ein sicheres Anzeichen dafür, daß keine korrekte Verbindung zustandegekommen ist (beispielsweise weil die Baugruppen-Leiterplatte zuvor nicht bis zum Anschlag in den elektrischen Verbinder eingeschoben wurde) und eröffnet die Möglichkeit, derartige Fehler frühzeitig und schnell zu erkennen und zu beheben.

Will man die in der Figur 2C gezeigte Verbindungsstellung des elektrischen Verbinders wieder lösen, um die Baugruppen-Leiterplatte oder die Rückwand-Leiterplatte auszutauschen, mit zusätzlichen Bauteilen zu bestücken oder zu warten, so muß einfach nur die Druckstange vom elektrischen Verbinder zurück gezogen werden. Dieses Herausziehen der Druckstange aus der Abschlußblende der Baugruppen-Leiterplatte bewirkt infolge der in diesem Zustand bestehenden Verbindung zwischen der Druckstange und dem Kniehebel gleichzeitig eine Betätigung des Kniehebels. Sobald der Kniehebel über dessen Totpunkt zurückgeschwenkt ist, sind die erste und die zweite Hälfte des elektrischen Verbinders und die Druckstange durch den Kniehebel nicht mehr festgehalten, d.h. sind frei beweglich. Dieser Zustand entspricht in etwa dem in der Figur 2B gezeigten Zustand.

Werden, wie vorstehend bereits als vorteilhaft erwähnt, Kontaktierungsvorrichtungen mit im wesentlichen ebenen Kontaktflächen verwendet, welche im Verbindungszustand mittels elastischer Elemente wie Federn oder dergleichen im wesentlichen frontal aufeinandergepreßt werden, kann das Aufklappen der ersten und der zweiten Hälfte des elektrischen Verbinders in die Montagestellung mit einem sehr geringen Kraftaufwand erfolgen; lediglich zur Überwindung des Totpunkts des Kniehebels wäre dann eine gewisse Kraft erforderlich.

Das in der Montagestellung des elektrischen Verbinders mögliche Herausnehmen der Baugruppen-Leiterplatte erfolgt, da in diesem Zustand weder mechanische noch elektrische Verbindungen zwischen dem elektrischen Verbinder und der Baugruppen-Leiterplatte bestehen, ebenfalls ohne Einsatz von Kraft.

Die Kombination der soeben nochmals erwähnten sogenannten Nullkraftverbinder mit der erfindungsgemäßen Betätigungshilfe ist besonders vorteilhaft, da hiermit eine nahezu gänzlich kraftfreie Verbindung oder Trennung von Leiterplatten möglich ist.

Es wurde somit eine Betätigungshilfe zum Bringen und/oder Lösen eines elektrischen Verbinders in bzw. aus dessen Verbindungsstellung geschaffen, welcher auch bei Leiterplattenverbindern und auf eine Art einsetzbar ist, durch die die Belastung der Leiterplatten beim Herstellen und Lösen der Verbindung einfach und zuverlässig auf ein Minimum reduzierbar ist.

Der erfindungsgemäße Aufbau ist darüber hinaus auch äußerst vorteilhaft in Systemen einsetzbar, bei denen es darauf ankommt, die elektrische Verbindung der zu verbindenden Anschlüsse in einer bestimmten Reihenfolge vorzunehmen, also wenn es beispielsweise erforderlich ist, die elektrische Verbindung der Masseanschlüsse vor der Verbindung der anderen Anschlüsse vorzunehmen.

In diesem Fall könnte vorgesehen werden, zur Verbindung der zuerst zu kontaktierenden Anschlüsse herkömmliche Verbinder mit Messer- und Federleisten oder dergleichen vorzusehen, während für die später zu kontaktierenden Anschlüsse das in der vorliegenden Anmeldung beschriebene Verbindungssystem verwendet werden könnte.

Beim Verbinden der zu verbindenden Leiterplatten würden die über die herkömmlichen Verbinder mit den Messer- und Federleisten oder dergleichen kontaktierbaren Anschlüsse sofort beim Aufstecken der Baugruppen-Leiterplatte auf die Rückwand-Leiterplatte miteinander elektrisch und mechanisch verbunden werden. Die über das erfindungsgemäße Verbindungssystem kontaktierbaren Anschlüsse sind durch das Aufstecken weder elektrisch noch mechanisch mit dem elektrischen Verbinder verbunden; die Verbindung erfolgt vielmehr erst bei Betätigung des Haltemechanismus mittels der Betätigungshilfe und kann gegebenenfalls wiederum selektiv in einer bestimmten weiteren Reihenfolge vorgenommen werden.

Anstelle des gemischten Vorsehens verschiedener Verbindungssysteme zur zeitlich gestaffelten Verbindung der zu verbindenden Anschlüsse können auch mehrere separat betätigbare Verbindungssysteme der in der vorliegenden Anmeldung beschriebenen Art vorgesehen werden.

Das beschriebene Verbindungssystem vereint somit eine Vielzahl von positiven Eigenschaften, welche mit herkömmlichen Systemen überhaupt nicht oder nur unter Inkaufnahme von nicht unerheblichen Nachteilen realisierbar sind.

## Patentansprüche

1. Betätigungshilfe zum Bringen und/oder Lösen eines elektrischen Verbinders in bzw. aus dessen Verbindungsstellung, in welcher er eine erste Leiterplatte mit einer zweiten Leiterplatte elektrisch verbindet,
**dadurch gekennzeichnet**,
daß ein dem elektrischen Verbinder (1) zugewandter Endabschnitt der Betätigungshilfe (31) derart ausgebildet ist, daß damit ein Haltemechanismus (14) betätigbar ist, welcher in der Lage ist, den elektrischen Verbinder (1) in der Verbindungsstellung zu halten, und
daß ein dem elektrischen Verbinder (1) abgewandter Endabschnitt der Betätigungshilfe (31) sich in einen Bereich außerhalb der ersten und/oder zweiten Leiterplatte (2, 3) erstreckt und so ausgebildet ist, daß eine Betätigung dieses Endabschnittes eine Betätigung des Haltemechanismus (14) durch den dem elektrischen Verbinder (1) zugewandten Endabschnitt der Betätigungshilfe (31) auslöst.

2. Betätigungshilfe nach Anspruch 1,
**dadurch gekennzeichnet**,
daß im Verbindungszustand die zweite Leiterplatte (3) unter Zwischenschaltung des elektrischen Verbinders (1) im wesentlichen senkrecht auf die erste Leiterplatte (2) aufgesteckt ist.

3. Betätigungshilfe nach Anspruch 1 oder 2,
**dadurch gekennzeichnet**,
daß der elektrische Verbinder (1) auf der ersten Leiterplatte (2) durch Führungs- und Haltewände (21) mit Haltelappen (22) gehalten wird.

4. Betätigungshilfe nach einem der vorhergehenden Ansprüche,
**dadurch gekennzeichnet**,
daß der elektrische Verbinder (1) eine erste und eine zweite Hälfte (12, 13) aufweist, welche im Verbindungszustand des elektrischen Verbinders die zweite Leiterplatte (3) zwischen sich festhalten und dabei die zweite Leiterplatte elektrisch und mechanisch mit dem elektrischen Verbinder verbinden, und welche in einer Montagestellung des elektrischen Verbinders auseinandergeklappt sind und dabei ein im wesentlichen kraftfreies Einführen bzw. Entnehmen der zweiten Leiterplatte in bzw. aus dem elektrischen Verbinder ermöglichen.

5. Betätigungshilfe nach einem der vorhergehenden Ansprüche,
**dadurch gekennzeichnet**,
daß der Haltemechanismus (14) derart ausgebildet ist, daß er sich nach Bringen in eine Haltestellung, in welcher der elektrische Verbinder in der Verbindungsstellung gehalten wird, selbständig in dieser Position hält.

6. Betätigungshilfe nach einem der vorhergehenden Ansprüche,
**dadurch gekennzeichnet**,
daß der Haltemechanismus (14) derart ausgebildet ist, daß dessen Bringen in die Haltestellung zugleich ein Bringen des elektrischen Verbinders (1) in die Verbindungsstellung bewirkt.

7. Betätigungshilfe nach einem der vorhergehenden Ansprüche,
**dadurch gekennzeichnet**,
daß der Haltemechanismus (14) derart ausgebildet ist, daß, wenn er sich nicht in der Haltestellung befindet, sich der elektrische Verbinder (1) in der Montagestellung befindet.

8. Betätigungshilfe nach einem der vorhergehenden Ansprüche,
**dadurch gekennzeichnet**,
daß der Haltemechanismus (14) durch einen oder mehrere Kniehebel gebildet wird.

9. Betätigungshilfe nach Anspruch 8,
**dadurch gekennzeichnet**,
daß der mindestens eine Kniehebel schwenkbar an der ersten Hälfte (12) oder der zweiten Hälfte (13) des elektrischen Verbinders (1) angebracht ist.

10. Betätigungshilfe nach einem der vorhergehenden Ansprüche,
**dadurch gekennzeichnet**,
daß die Betätigungshilfe (31) durch eine oder mehrere Druckstangen gebildet ist.

11. Betätigungshilfe nach Anspruch 10,
**dadurch gekennzeichnet**,
daß die mindestens eine Druckstange von dem dem elektrischen Verbinder (1) zugewandten Endabschnitt der zweiten Leiterplatte (3) zu dem gegenüberliegenden Endabschnitt der zweiten Leiterplatte verläuft und über diesen noch hinausragt.

12. Betätigungshilfe nach Anspruch 10 oder 11,
**dadurch gekennzeichnet**,
daß die mindestens eine Druckstange parallel zur Oberfläche der zweiten Leiterplatte (3) geführt ist.

13. Betätigungshilfe nach einem der Ansprüche 10 bis 12,
**dadurch gekennzeichnet**,
daß die mindestens eine Druckstange in auf der zweiten Leiterplatte (3) angebrachten Führungsvorrichtungen (32, 33) geführt ist.

14. Betätigungshilfe nach einem der Ansprüche 10 bis 13,
**dadurch gekennzeichnet**,
daß die mindestens eine Druckstange derart ausgebildet ist, daß ein Drücken auf dieselbe ein Drücken auf den Kniehebel bewirkt, was seinerseits zum einen ein Drücken der Hälfte des elektrischen Verbinders, an welchem der Kniehebel befestigt ist, in Richtung der Verbindungsstellung zur Folge hat, und was andererseits ein Strecken des Kniehebels zur Folge hat.

15. Betätigungshilfe nach Anspruch 14,
**dadurch gekennzeichnet**,
daß das Strecken des Kniehebels zur Folge hat, daß ein mit der zweiten Hälfte des elektrischen Verbinders in Eingriff stehender Endabschnitt des Kniehebels ein Drücken der zweiten Hälfte des elektrischen Verbinders in Richtung der Verbindungsstellung des elektrischen Verbinders bewirkt.

16. Betätigungshilfe nach einem der Ansprüche 14 oder 15,
**dadurch gekennzeichnet**,
daß die mindestens eine Druckstange derart ausgebildet ist, daß diese bei fortgesetztem Drücken ein Durchdrücken des Kniehebels über dessen Totpunkt und damit die selbständige Arretierung desselben in der Haltestellung zur Folge hat.

17. Betätigungshilfe nach Anspruch 16,
**dadurch gekennzeichnet**,
daß das Durchdrücken der Druckstange über den Totpunkt des Kniehebels ein hör- und fühlbares Ereignis ist.

18. Betätigungshilfe nach einem der Ansprüche 16 oder17,
**dadurch gekennzeichnet**,
daß die mindestens eine Druckstange an ihrem dem elektrischen Verbinder zugewandten Endabschnitt derart hakenförmig ausgebildet ist, daß sie spätestens von dem Zeitpunkt an, zu dem der Kniehebel zum Totpunkt gelangt, von diesem in einer gegenseitigen Verbindung gehalten wird, während sie in der Montagestellung des elektrischen Verbinders nicht fest mit dem Kniehebel verbunden ist.

19. Betätigungshilfe nach einem der vorhergehenden Ansprüche,
**dadurch gekennzeichnet**,
daß die zweite Leiterplatte (3) und die erste und die zweite Hälfte (12, 13) des elektrischen Verbinders (1) auf den einander im Verbindungszustand des elektrischen Verbinders jeweils gegenüberliegenden Oberflächen Kontaktierungsvorrichtungen für die elektrische Verbindung aufweisen.

20. Betätigungshilfe nach Anspruch 19,
**dadurch gekennzeichnet**,
daß an den Kontaktierungsvorrichtungen des elektrischen Verbinders (1) und der zweiten Leiterplatte (3) vorgesehene Kontaktflächen eine eine im wesentlichen überlappungsfreie Verbindung ermöglichende Gestalt aufweisen.

21. Betätigungshilfe nach Anspruch 20,
**dadurch gekennzeichnet**,
daß die Kontaktflächen der Kontaktierungsvorrichtungen eine Gestalt aufweisen, deren Ausdehnung in einer ersten Richtung größer ist als deren Ausdehnung in einer zweiten Richtung, wobei die erste Richtung eine zur im Kontaktflächenbereich und dessen Umgebung vorherrschenden Stromflußrichtung senkrechte Richtung ist, und wobei die zweite Richtung eine zur im Kontaktflächenbereich und dessen Umgebung vorherrschenden Stromflußrichtung parallele Richtung ist.

22. Betätigungshilfe nach Anspruch 21,
**dadurch gekennzeichnet**,
daß die Kontaktflächen der Kontaktierungsvorrichtungen eine eine großflächige Kontaktierung ermöglichende Gestalt in Form eines im wesentlichen ebenen oder gekrümmten Flächenabschnittes aufweisen.

23. Betätigungshilfe nach Anspruch 22,
**dadurch gekennzeichnet**,
daß die Kontaktflächen der Kontaktierungsvorrichtungen des elektrischen Verbinders (1) mit elastischen Elementen in Verbindung stehen, welche im Verbindungszustand des elektrischen Verbinders aus ihrer Ruhelage ausgelenkt sind und somit die Ausübung einer im wesentlichen frontalen Andruckkraft der Kontaktflächen der Kontaktierungsvorrichtungen des elektrischen Verbinders (1) auf die Kontaktflächen der Kontaktierungsvorrichtungen der zweiten Leiterplatte (3) bewirken.
